# EUROPEAN PATENT APPLICATION

(11) **EP 3 270 427 A1**
(43) Date of publication of application: **17.01.2018**
(21) Application number: 15884637.8
(22) Date of filing: 15.06.2015
(51) Int. Cl.: H01L 33/54

(54) **LIGHT-EMITTING ELEMENT AND IMAGE DISPLAY DEVICE**

(30) Priority: 12.03.2015 JP 2015048979
(71) Applicant: Mitsubishi Electric Corporation, Chiyoda-ku Tokyo 100-8310 (JP)
(72) Inventor: KIRIDOSHI Satoru, Tokyo 100-8310 (JP); HANAMURA Toshiaki, Tokyo 100-8310 (JP); TERANISHI Masato, Tokyo 100-8310 (JP); NAKAGUCHI Keisuke, Tokyo 100-8310 (JP); KAWAGUCHI Hironobu, Tokyo 102-0073 (JP)
(74) Representative: Studio Torta S.p.A.
(86) International application number: PCT/JP2015/067203
(87) International publication number: WO 2016/143151

(57) **Abstract**

A light-emitting element (1) includes a casing (2) including a recess (6), an LED chip (3g) disposed within the recess (6) of the casing (2), and a sealing member (8) permitting passage of light emitted by the LED chip (3g) and including a raised curved surface that is curved outward from the casing (2) at an interface (9) with a space external to the casing (2).

## Description

### Technical Field

The present disclosure relates to a light-emitting element and a video display device including the light-emitting element.

### Background Art

A large-sized video display device with light-emitting elements arranged in a matrix of rows and columns on a display screen is often located outdoors, such as in a sports facility, on a building wall, or the like. The video display device displays text, pictures, and other images on the display screen by causing change in brightness and emission of each light-emitting element in accordance with an external input video signal (see, for example, Patent Literatures 1 and 2).

The light-emitting element for use in the video display device includes a light source, for example a light-emitting diode (LED) or the like, disposed in a recess of a casing, and a transparent resin with which the recess is filled. Light rays emitted by the light source are transmitted through the transparent resin to the exterior. An interface between the transparent resin and a space external to the casing, that is, an emission surface of the light-emitting element is made flat (see, for example, Patent Literatures 3 and 4).

### Citation List

### Patent Literature

Patent Literature 1: Unexamined Japanese Patent Application Kokai Publication No. H11-305689
Patent Literature 2: Unexamined Japanese Patent Application Kokai Publication No. 2006-308713
Patent Literature 3: Unexamined Japanese Patent Application Kokai Publication No. 2012-109461
Patent Literature 4: Unexamined Japanese Patent Application Kokai Publication No. 2015-26871

### Summary of Invention

### Technical Problem

Since the large-sized video display device is mainly located outdoors as described above, sunlight may be incident on the display screen and reflected by the display screen. Reflection of sunlight on the display screen reduces contrast of an image displayed on the display screen because light emitted by the light-emitting element is blended into the reflected rays. Reduced contrast of the image may cause a viewer to suffer from poor viewability of the image. Thus a video display device is needed that allows reduction or elimination of contrast degradation due to external incident light, such as sunlight.

For example, the video display devices disclosed in Patent Literatures 1 and 2 provide visor-like members arranged between horizontal rows of light-emitting elements to prevent sunlight from entering the display screen obliquely from above so as to reduce or eliminate occurrence of reflection light. The visor-like members having such arrangement can block sunlight effectively when the sun is high in the sky. However, when the sun is low in the sky, sunlight is incident at a small angle, and thus the sunlight passes below the visor-like members and reaches the display screen. The increased length of visor-like members may block entrance of sunlight even when the sun is low in the sky. Unfortunately, the increased length of visor-like members may provide poor viewability of light emitted by the light-emitting elements obliquely from below or obliquely from above, which narrows a viewable range (viewing angle) of the image displayed on the display screen. The visor-like members thus have a limited height. Thus such visor-like members do not block sunlight entering the display screen when the sun is low in the sky such as in the morning and evening.

Typical emission surface of the light-emitting element is made flat as in the light-emitting elements disclosed in Patent Literatures 3 and 4. Such flatness causes rays of sunlight incident on the emission surface of the light-emitting element to be all reflected in the same direction. All the reflected rays together with light rays emitted by the light-emitting elements enter eyes of a viewer on a path of reflected sunlight, and thus the light rays emitted by the light-emitting elements are blended into the reflected rays, which causes the display screen to appear uniformly bright for the viewer. Briefly, the reduced contrast of the image causes the bright appearance of the entire image. As a result, the viewer suffers from poor viewability of the image on the display screen.

The present disclosure has been made based on the above-described background, and an objective of the present disclosure is to provide a light-emitting element that, when external light rays are incident on the light-emitting element, does not reflect all the external light rays in the same direction. Another objective of the present disclosure is to provide a video display device that is less likely to provide poor viewability of the image on the display screen even when the external light is incident on the display screen.

### Solution to Problem

To achieve the foregoing objectives, the present disclosure provides a light-emitting element including a casing including a recess, a light source disposed in the recess of the casing, and a transparent member including a raised curved surface that is curved outward from the casing and that is an interface with a space external to the casing, the transparent member permitting passage of light emitted by the light source.

### Advantageous Effects of Invention

The present disclosure provides the light-emitting element having the raised curved surface by which external light rays entering the light-emitting element are reflected and diverged in various directions, which prevents all the reflected rays from entering eyes of a viewer who views the light-emitting element, regardless of the viewing direction. This thus eliminates or reduces occurrence of phenomenon that causes the display screen to appear uniformly bright due to blending of light emitted by the light-emitting elements into the reflected rays. That is, the image contrast degradation is eliminated or reduced. This improves viewability of the image of the video display device in the environment in which the video display device is exposed to external light.

### Brief Description of Drawings

FIG. 1A is a plan view of a light-emitting element according to an embodiment of the present disclosure;
FIG. 1B is a side view of the light-emitting element illustrated in FIG. 1A;
FIG. 1C is a cross-sectional view of the light-emitting element illustrated in FIG. 1A, taken along line A-A' of FIG. 1A;
FIG. 2 is a side view illustrating an effect of the light-emitting element illustrated in FIGS. 1A to 1C;
FIG. 3 is a schematic diagram of a video display device according to an embodiment of the present disclosure;
FIG. 4 is a schematic diagram of the video display device illustrated in FIG. 3 in use;
FIG. 5 is a side view illustrating an effect of the video display device illustrated in FIG. 3;
FIG. 6 is a side view illustrating a size of expansion of a curved portion of a transparent member of the light-emitting element illustrated in FIGS. 1A to 1C;
FIG. 7 is a schematic cross-sectional view, corresponding to that of FIG. 1C, illustrating a variation of the light-emitting element;
FIG. 8 is a schematic cross-sectional view, corresponding to that of FIG. 1C, illustrating another variation of the light-emitting element; and
FIG. 9 is a schematic cross-sectional view, corresponding to that of FIG. 1C, illustrating yet another variation of the light-emitting element.

### Description of Embodiments

Embodiments of a light-emitting element and a video display device according to the present disclosure are described below in detail with reference to the drawings. The same reference signs are used for the same or equivalent parts throughout the drawings.

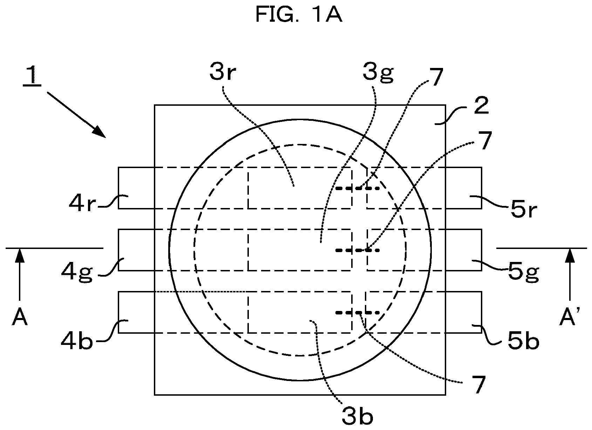

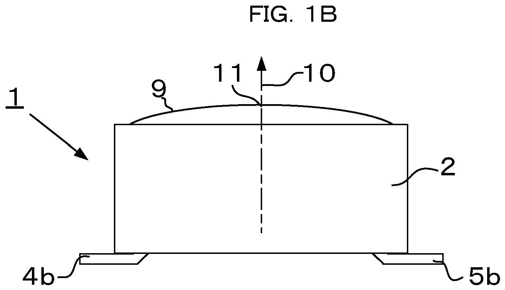

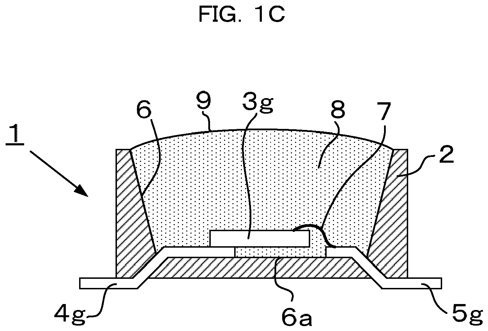

Each of FIGS. 1A to 1C is a schematic diagram of a light-emitting element 1 according to an embodiment of the present disclosure. FIG. 1A is a plan view of a light-emitting element 1, and FIG. 1B is a side view of the light-emitting element 1. FIG. 1C is a cross-sectional view of the light-emitting element 1, taken along line A-A' of FIG. 1A.

As illustrated in FIG. 1A, the light-emitting element 1 includes three LED chips 3r, 3g, and 3b that are housed in a casing 2 and serve as a light source of the light-emitting element 1. The LED chips 3r, 3g, and 3b include light-emitting diodes that emit red light, green light, and blue light, respectively. The light-emitting element 1 can provide various emission colors by changing emission intensities (brightness) of the LED chips 3r, 3g, and 3b. Three sets of extraction electrodes 4r, 5r; 4g, 5g; and 4b, 5b include ends exposed to the exterior of the casing 2. The casing 2, which is a resin molding forming a shell of the light-emitting element 1, holds the LED chips 3r, 3g, and 3b or the like. Examples of materials of the casing 2 include, but are not limited to, a thermoplastic resin, such as a polyphthalamide resin, and a thermosetting resin, such as a silicone resin and an epoxy resin.

As illustrated in FIG. 1C, a recess 6 is formed in the casing 2. The extraction electrodes 4g and 5g are disposed in the recess 6. The extraction electrodes 4g and 5g extend outside the casing 2, and the ends thereof are exposed to the exterior of the casing 2 as described above. The extraction electrodes 4r, 5r, 4b, and 5b are also disposed similarly.

The LED chip 3g disposed in the recess 6 is mounted on the extraction electrode 4g, and electrically connected to the extraction electrode 4g. A bonding wire 7 has one end electrically connected to an upper surface of the LED chip 3g and another end electrically connected to the extraction electrode 5g. Similarly, the LED chips 3r and 3b are mounted on the respective extraction electrodes 4r and 4b, and electrically connected to the respective extraction electrodes 4r and 4b. The LED chips 3r and 3b are also electrically connected to the respective extraction electrodes 5r and 5b via the respective bonding wires 7. The recess 6 is filled with a transparent resin to form a sealing member 8. The sealing member 8, which is an example transparent member of the present disclosure, is a member for sealing the LED chips 3r, 3g, and 3b within the recess 6 by closing the recess 6. The sealing member 8 is a member for permitting passage of rays emitted by the LED chips 3r, 3g, and 3b. Examples of materials of the sealing member 8 include, but are not limited to an epoxy resin and a silicone resin.

The sealing member 8 bulges outside the casing 2, and has a raised curved surface, which has a convex lens shape, forming an interface 9 with a space external to the light-emitting element 1. As illustrated in FIG. 1B, the interface 9 has a center that is an intersection 11 of the interface 9 and an optical axis 10 of the LED chip 3g, and the intersection 11 is located farthest away from a bottom surface 6a of the recess 6. The interface 9 inclines so as to gradually approach the bottom surface 6a of the recess 6 as the interface 9 gets farther away from the center (intersection 11). The inclination of the interface 9 increases with an increasing distance from the intersection 11.

The sealing member 8 is an example transparent member of the present disclosure. As described above, the sealing member 8 is made of a transparent resin, and the light emitted by the LED chips 3r, 3g, and 3b is transmitted through the sealing member 8 to the outside of the casing 2. The sealing member 8 closes an opening of a top side of the casing 2, that is, an entrance of the recess 6.

The light-emitting element 1 is produced as in the following process. Firstly, the extraction electrodes 4r, 5r, 4g, 5g, 4b, and 5b are placed within a mold (not shown), and a resin is injected into the mold to mold the casing 2 while the extraction electrodes 4r, 5r, 4g, 5g, 4b, and 5b are fixed to the casing 2. As described above, the casing 2 can be, for example, made of a thermoplastic resin, such as a polyphthalamide resin, or a thermosetting resin, such as a silicone resin and an epoxy resin. Light-reflecting particles, such as titanium dioxide, may be mixed with the resin to improve optical reflectivity.

After the casing 2 is molded, the LED chips 3r, 3g, and 3b are bonded to the extraction electrodes 4r, 4g, and 4b within the recess 6 of the casing 2. Then the LED chips 3r, 3g, and 3b are electrically connected to the extraction electrodes 5r, 5g, and 5b via bonding wires 7.

Finally, a liquid transparent resin is injected into the recess 6 to form the sealing member 8. During the injection, an amount of resin in excess of the capacity of the recess 6 is injected into the recess 6 at a low injection rate. Injection of the resin at a low rate enables a liquid surface of the resin passing beyond the recess 6 to form a bulge in a convex lens shape under the action of surface tension. This bulging resin is left to set to form an interface 9 having a convex lens shape. As described above, the sealing member 8 can be, for example, made of an epoxy resin or a silicone resin.

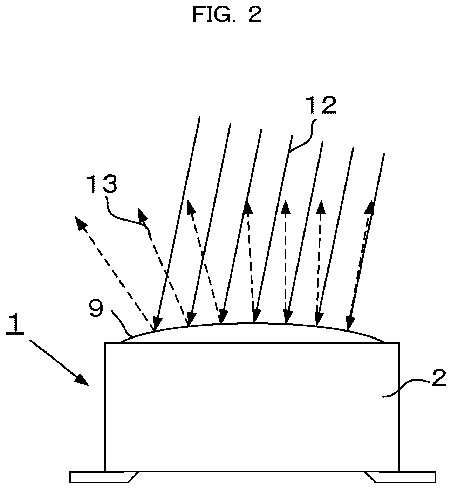

Next, the effects of the light-emitting element 1 are described with reference to FIG. 2. Since sunlight 12 is collimated light as illustrated in FIG. 2, rays of the sunlight 12 are all incident in the same direction on the interface 9 of the sealing member 8 of the light-emitting element 1. However, the rays of the sunlight 12 are reflected in various directions because the interface 9 of the sealing member 8 forms a raised curved surface that is curved outward from the casing 2. The directions of the reflected rays 13 vary depending on positions of the interface 9 on which the rays of the sunlight 12 strike. That is, the rays 13 reflected by the interface 9 diverge. Thus all the rays of sunlight 12 are not reflected in the same direction on the interface 9. This prevents all the reflected rays 13 from entering eyes of a viewer who views the light-emitting element 1, regardless of the viewing direction.

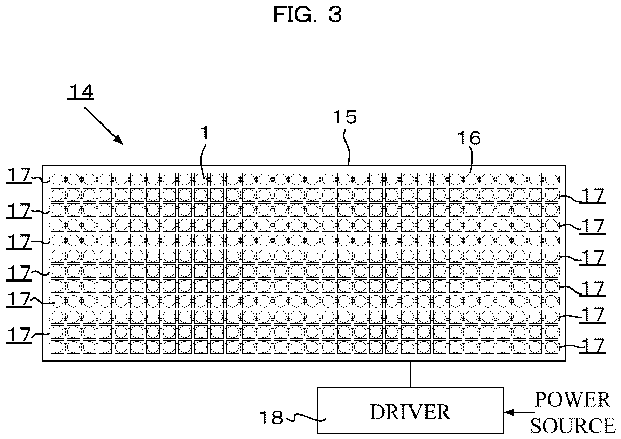

FIG. 3 is a schematic view of a video display device 14 according to an embodiment of the present disclosure. As illustrated in FIG. 3, a display screen 15 of the video display device 14 includes light-emitting elements 1 arranged in a matrix of rows and columns on a board 16. That is, the light-emitting elements 1 are arranged in a horizontal direction to form rows of light-emitting elements 17, and in a vertical direction to form columns of light-emitting elements 17. The board 16 includes unillustrated wiring patterns formed thereon, and the extraction electrodes 4r, 5r, 4g, 5g, 4b, and 5b (not shown in FIG. 3) of each light-emitting element 1 are connected to the respective wiring patterns.

The video display device 14 includes a driver 18. The driver 18, which is connected to each light-emitting element 1 via the above-mentioned wiring patterns, is an electric circuit to distribute power supplied by a power source to each light-emitting element 1 and to individually adjust brightness and emission color of the light-emitting elements 1.

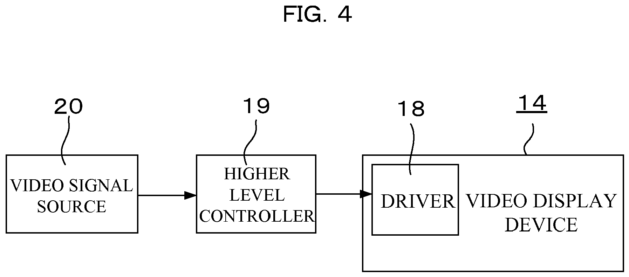

As illustrated in FIG. 4, the video display device 14 is used by connection to a video signal source 20 via a higher level controller 19. The video signal source 20 can be, for example, a server to output a prestored video signal to the higher level controller 19. The higher level controller 19, which is a computer, converts a video signal input by the video signal source 20 in accordance with an arrangement of the light-emitting elements 1 in the video display device 14, determines the brightness and emission color of the individual light-emitting element 1, and commands the driver 18.

In this way, the video display device 14 individually adjusts the brightness and emission color of the light-emitting elements 1 arranged on the board 16, and displays an image on the display screen 15. In addition, the video display device 14 displays a moving image (video) by changing the image over time. The display screen 15 of the video display device 14 corresponds to a screen of a small-sized video display device, for example a liquid crystal display, and a single light-emitting element 1 corresponds to a single pixel.

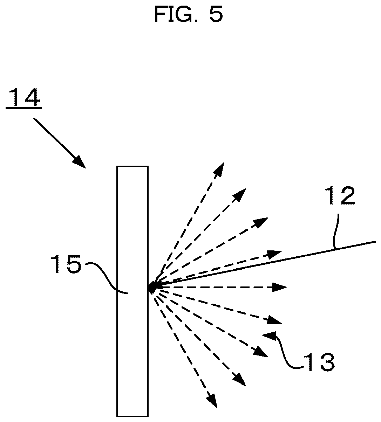

As described above, the rays of sunlight 12 incident on the light-emitting element 1 are reflected in various directions, and thus as illustrated in FIG. 5, the reflected rays 13 of the sunlight 12 entering the video display device 14 diverge in various directions. Thus all the rays of sunlight 12 entering the video display device 14 are not reflected in the same direction.

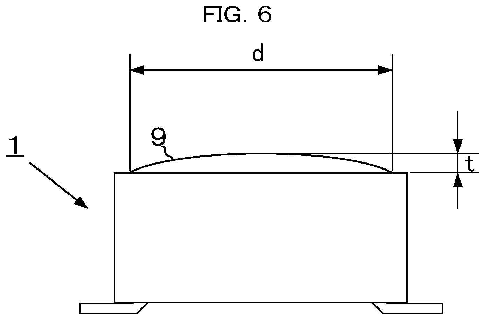

Although FIGS. 1 and 2 depict the interface 9 as having a large curve, the raised curved surface of the interface 9 is not limited to such a pronounced curve. As illustrated in FIG. 6, if the maximum height *t* of the interface 9 measured from an end surface of the casing 2 is *d*/100 or more with *d* being the diameter of the recess 6, the above-mentioned effects can be obtained. Briefly, a slightly bulging interface 9 provides the above-mentioned effects. The convex surface of the interface 9 is not limited to a spherical surface. The raised curved surface may be an aspheric surface.

As described above, when external light rays are incident on a surface of a light-emitting element according to the present disclosure, the reflected rays diverge in various directions. Thus a video display device including such light-emitting elements according to the present disclosure arranged in a matrix of rows and columns on a board provides divergence of rays reflected in various directions when external light rays enter the video display device. Thus, a viewer does not suffer from degradation of image contrast when viewing the video display device in any direction. Consequently, the present disclosure provides improvement of viewability of the image of the video display device located in the environment in which the video display device is exposed to external light.

The above embodiments describe some examples of specific embodiments of the present disclosure, and the technical scope of the present disclosure is not limited by the embodiments. Any variation or modification can be made within the scope of the technical idea as that defined in the claims to implement the present disclosure. Any addition of elements that are not disclosed in the above embodiments is to be allowed.

The above embodiments provide an example arrangement of the sealing member 8 having a central axis concentric with the optical axis 10, but a relationship between both the axes is not limited to such a coaxial one. The central axis of the sealing member 8 and the optical axis 10 may be different. A three-dimensional curved surface like a convex lens is exemplified as the raised curved surface forming the interface 9 of the sealing member 8, but the raised curved surface is not limited to the three-dimensional curved surface. The raised curved surface may be a two-dimensional curved surface.

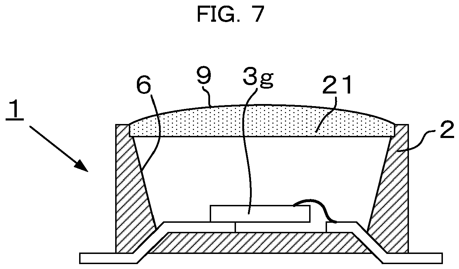

The above embodiments provide an example process of forming the sealing member 8 by injecting a liquid resin into the recess 6 of the casing 2, filling the recess 6 with the liquid resin, and then setting the liquid resin, but the transparent member is not limited to the sealing member 8 produced by the process. For example, as illustrated in FIG. 7, a transparent member 21 produced in another process, that is, a pre-solidified transparent member 21 may be fitted in the recess 6.

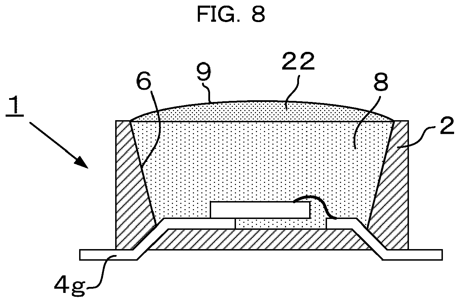

Alternatively, after flattening of an upper surface of the sealing member 8, another member having a raised curved surface may be additionally provided on the upper surface of the sealing member 8. For example, as illustrated in FIG. 8, additional member 22 made of a transparent material and having a raised upper surface in a convex lens shape may be mounted on the sealing member 8 having a flattened upper surface. The additional member 22, which is preformed in the illustrated shape, may be mounted on and attached to the sealing member 8 after the preformation. Alternatively, the additional member 22 may be formed by adding a liquid resin dropwise on the sealing member 8 to form a raised surface of the liquid resin under the action of surface tension and setting the raised surface as it is. Alternatively, the additional member 22 may be formed by disposing a mold on the sealing member 8 and injecting a resin material into the mold.

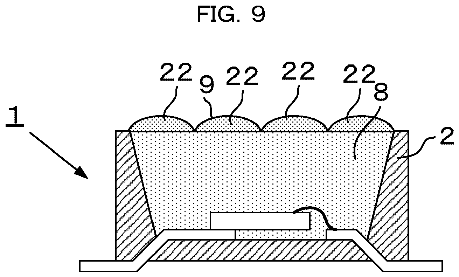

Additional members 22 as illustrated in FIG. 9 may be formed on the sealing member 8 by adding a liquid resin dropwise at multiple positions on the sealing member 8. In this case, a smaller amount of liquid resin droplets per a single position provides greater surface tension compared with the weight of liquid resin. This facilitates higher raised formation of the additional member 22.

The structure as illustrated in FIG. 9 may be, of course, provided by preparing additional members 22 beforehand and attaching the prepared additional members 22 on the sealing member 8. Alternatively, the additional members 22 may be formed by disposing a mold on the sealing member 8 and injecting a resin material into the mold.

The number of LED chips 3r, 3g, and 3b included in the light-emitting element 1 is not limited to three. The number may also be one or two, or may be four or more. The emission color of the light-emitting element 1 is not limiting. Any combination of emission colors is possible. A chip including light-emitting diodes having different emission colors may be provided on a single board as a light source.

Although the higher level controller 19 is provided as an external device of the video display device 14 in the above embodiments, the higher level controller 19 may be incorporated into the video display device 14.

Although sunlight is exemplified as a specific example of the external light in the above embodiments, the external light in the present disclosure is not limited to the sunlight. Examples of the external light include rays entering the light-emitting elements 1 and the video display device 14 from any types of artificial illumination such as indoor illumination devices and outdoor illumination devices.

The foregoing describes some example embodiments for explanatory purposes. Although the foregoing discussion has presented specific embodiments, persons skilled in the art will recognize that changes may be made in form and detail without departing from the broader spirit and scope of the invention. Accordingly, the specification and drawings are to be regarded in an illustrative rather than a restrictive sense. This detailed description, therefore, is not to be taken in a limiting sense, and the scope of the invention is defined only by the included claims, along with the full range of equivalents to which such claims are entitled.

This application claims the benefit of Japanese Patent Application No. 2015-048979, filed on March 12, 2015, the entire disclosure of which is incorporated by reference herein.

### Reference Signs List

1 Light-emitting element
2 Casing
3r, 3g, 3b LED chip
4r, 4g, 4b, 5r, 5g, 5b Extraction electrode
6 Recess
6a Bottom surface
7 Bonding wire
8 Sealing member
9 Interface
10 Optical axis
11 Intersection
12 Sunlight
13 Reflected ray
14 Video display device
15 Display screen
16 Board
17 Rows and columns of light-emitting elements
18 Driver
19 Higher level controller
20 Video signal source
21 Transparent member
22 Additional member

## Claims

1. A light-emitting element, comprising:
a casing including a recess;
a light source disposed in the recess of the casing; and
a transparent member including a raised curved surface that is curved outward from the casing and that is an interface with a space external to the casing, the transparent member permitting passage of light emitted by the light source.

2. The light-emitting element according to claim 1, wherein the recess is filled with a sealing member for sealing the light source in the recess, and the transparent member comprises an additional member including a raised curved surface that is curved outward from the casing and mounted on a surface of the sealing member.

3. The light-emitting element according to claim 2, wherein the transparent member comprises a plurality of the additional members mounted on the surface of the sealing member.

4. A video display device comprising a plurality of the light-emitting elements according to any one of claims 1 to 3, wherein the plurality of the light-emitting elements are arranged in a matrix of rows and columns.
